# EUROPEAN PATENT SPECIFICATION

(11) **EP 1 703 571 B1**
(45) Date of publication and mention of the grant of the patent: **05.10.2011**
(21) Application number: 04807733.3
(22) Date of filing: 24.12.2004
(51) Int. Cl.: H01L 41/08, H01L 41/187, H01L 41/22, H03H 9/17, H04R 17/00

(54) **PIEZOELECTRIC DEVICE**
PIEZOELEKTRISCHES BAUELEMENT
DISPOSITIF PIEZOELECTRIQUE

(30) Priority: 26.12.2003 JP 2003433017
(43) Date of publication of application: 20.09.2006
(73) Proprietor: Ogawa, Toshio, Fukuroi-shi, Shizuoka 437-8555 (JP); JFE Mineral Company, Tokyo 1000005 (JP)
(72) Inventor: OGAWA, Toshio, Fukuroi-shi, Shizuoka 4378555 (JP)
(74) Representative: HOFFMANN EITLE
(86) International application number: PCT/JP2004/019376
(87) International publication number: WO 2005/064699

(56) References cited:
- EP-A- 1 479 796
- JP-A- 4 245 488
- JP-A- 2003 282 986
- US-A1- 2002 153 809

## Description

### Technical Field

The present invention relates to a piezoelectric device, and more particularly to a piezoelectric device having a giant-lateral-effect piezoelectric characteristic imparted thereto.

### Background Art

The present inventor paid attention to the fact that a piezoelectric single crystal element has an electromechanical coupling factor (k₃₃) not smaller than 80% in the polarization direction (longitudinal vibration mode), and is thereby adapted for various usages, but nevertheless its electromechanical coupling factor (k₃₁) in the direction (lateral vibration mode) perpendicular to the polarization direction, is 28 to 62%, which is smaller than the electromechanical coupling factor (k₃₃) in the polarization direction (longitudinal vibration mode). Thus, the present inventor has intensively investigated the reason of the fact that the piezoelectric single crystal element has such large electromechanical coupling factor (k₃₃) in the polarization direction (longitudinal vibration mode), but nevertheless has the small and greatly varying electromechanical coupling factor (k₃₁) in the direction (lateral vibration mode) perpendicular to the polarization direction. On the basis of the result of the investigation, the present inventor believed that the above described phenomenon is due to the fact that the domain structure formed by an electric dipole associated with the direction perpendicular to the polarization direction of the polarized piezoelectric single crystal element is formed by plural domains (multi-domain), not by a single domain (mono-domain), and thereby drew the conclusion that by controlling the domain structure so as to be formed by a mono-domain (referred to as the mono-domain formation), a piezoelectric single crystal element having a more excellent performance than the conventional one can be fabricated. Whether a sample of a single crystal plate is formed by a mono-domain or not, can be easily judged by observing the sample using a transmission type polarization microscope under crossed Nicols (orthogonal polarization), and by analyzing vibration modes obtained from the frequency response of impedance of the single crystal plate, (because only one group of vibration modes can be fundamentally obtained in the case of mono-domain vibration).

On the basis of this recognition, the present inventor has already developed a domain controlled piezoelectric single crystal element having a giant-lateral-effect piezoelectric performance, and a fabrication method thereof (see, for example, patent document 1). The developed domain controlled piezoelectric single crystal element, which is formed of a piezoelectric single crystal material having an electromechanical coupling factor k₃₃ ≥ 80% in a longitudinal vibration mode in the polarization direction and a piezoelectric distortion constant d₃₃ ≥ 800 pC/N, is characterized by having an electromechanical coupling factor k₃₁ ≥ 70% in a lateral vibration mode in the direction perpendicular to the polarization direction, a piezoelectric distortion constant -d₃₁ ≥ 1200 pC/N, and further a frequency constant fc₃₁ (= fr·L) ≤ 650 Hz·m which is a product of a resonance frequency fr in the lateral vibration mode relating to k₃₁ in the direction perpendicular to the polarization direction and a length L in the vibration direction of the element.

The present inventor has also developed a piezoelectric single crystal element formed of the piezoelectric single crystal material as specified by the following item of (a) or (b).
(a) A solid solution which is composed of X-Pb (A₁, A₂, ---, B₁, B₂---) O₃ + (1-X) PbTiO₃ (0<x<1), where A₁, A₂,are one or plural elements selected from a group of Zn, Mg, Ni, Lu, In and Sc and B₁, B₂, --- are one or plural elements selected from a group of Nb, Ta, Mo and W, and in which the total W of the ionic valences of the element group in parentheses in a chemical formula: Pb (A₁Y₁a₁, A₂Y₂a₂, ---, B₁Z₁b₁, B₁Z₂b₂ ---) O₃ satisfies charges: W = a₁·Y₁+a₂Y₂+ --- b₁·Z₁+b₂Z₂+ -- = 4 +, where ionic valences of A₁, A₂ -- are respectively set to a₁, a₂, ---, composition ratios of A₁, A₂, --- in the chemical formula are respectively set to Y₁, Y₂, ---, and where ionic valences of B₁, B₂, --- are respectively set to b₁, b₂ ---, composition ratios of B₁, B₂ --- in the chemical formula are respectively set to Z₁, Z₂, ---.
(b) The material (a) added with 0.5 ppm to 1% by mass of one or two of Mn and Cr.

On the other hand, there is disclosed a technique in which a diaphragm of a piezoelectric single crystal element is provided in a tactile section that is connected to a data processing section attached to the wrist of a hearing and language handicapped person and that is fitted to the fingertip of the person, in which a large displacement amount and force is obtained at a low voltage by providing the element with a maximum electromechanical coupling factor of a piezoelectric material and with a very high piezoelectric constant, and in which sound information such as voice is decomposed into frequencies to vertically vibrate each tactile pin, thereby making exact vibration pattern information transmitted to the skin of the fingertip of the person (see, for example, patent document 2).

This technique, in which a solid solution single crystal Pb[(Zn_{1/3}Nb_{2/3}) _{0.91}Ti_{0.09}] O₃ (PZNT91/9) made of Pb(Zn_{1/3}Nab_{2/3}) O₃ (PZN) and PbTiO₃ (PT) is used as the piezoelectric material, converts a voice signal to a vibration pattern on the basis of the piezoelectric effect of the material, so as to make the vibrational stimulus exhibited at the fingertip via a vibration pin. This tactile stimulating device adopts a constitution in which a conductive plate is sandwiched between upper and lower piezo-plates so as to be integrated with the plates, in which plural cut lines are formed from one end of the integrated plate to provide plural piezo-bimorph elements, and in which either the piezo-plate or the conductive plate is used as a common electrode, the other is used as a segment electrode, and metallic wires with a predetermined length are fixed to each tip part of the piezo bimorph elements mounted on a circuit board.

Further, in this tactile stimulating device, the diaphragm provided in the tactile section mounted at the fingertip is formed of a piezoelectric single crystal element of PZNT91/9, so as to obtain a maximum electromechanical coupling factor (k₃₃ = 92%) in the piezoelectric material, and a high piezoelectric constant (d₃₃=1500 pC/N). This enables the tactile stimulating device to serve as a tactile section of an auditory sense assisting device which is capable of obtaining a large displacement amount and force, decomposing the sound information such as voice into frequencies, and thereby continuously transmitting exact vibration pattern information to the skin sensibility at the fingertip. However, in relation to this technique, there is no description about the lateral effect piezoelectric characteristic, and in particular, about the giant-lateral-effect piezoelectric performance which the present inventor found (in which a lateral-vibration-mode electromechanical coupling factor k₃₁ in the direction perpendicular to the polarization direction is not smaller than 70%, and the piezoelectric distortion constant -d₃₁ is not smaller than 1200 pC/N, by domain control).
[Patent document 1]: Japanese Patent Laid-Open No. 2003-282986 (page 2 to 8, Fig. 1)
[Patent document 2]: Japanese Patent Laid-Open No. 2002-169462 (page 2 to 6, Fig. 1)
[Patent document 3]: EP 1 479 796

### Disclosure of the Invention

The present inventor used: a piezoelectric unimorph element and a piezoelectric bimorph element, formed by sticking a metal plate to a piezoelectric single crystal plate made such as of a Pb (Zn_{1/3}Nb_{2/3}) O₃-PbTiO₃ solid solution single crystal (for example as a specific composition, Pb[(Zn_{1/3}Nb_{2/3}) _{0.91}Ti_{0.09}] O₃, hereinafter abbreviated as PZNT91/09) or a Pb(Mg_{1/3}Nb_{2/3}) O₃-PbTiO₃ solid solution single crystal (hereinafter abbreviated as PMNT), in which single crystals with a lateral-vibration-mode electromechanical coupling factor k₃₁ not smaller than 70% is obtained by domain control; or an element formed by further making the single crystal plates and the metal plates repeatedly laminated with each other, and thereby, newly developed piezoelectric devices having bending-vibration-mode electromechanical coupling factors k_{b} not smaller than 50%, 60%, respectively, and having excellent secular (aging) characteristics.

The conventional piezoelectric device using a single crystal similar to the above described single crystal has a limit in its performance, and further its piezoelectric characteristic is significantly changed (deteriorated) with the lapse of time. These two problems have prevented the practical utilization of the conventional piezoelectric device. That is, the present invention aims at providing a piezoelectric device which is made of a single crystal having a giant-lateral-effect piezoelectric characteristic improved in the piezoelectric performance, and which has less secular deterioration of the piezoelectric characteristic.

The present invention has been made to solve the above described problems and to provide a piezoelectric device characterized by the following technical means. That is, according to the present invention, there is provided a piezoelectric device characterized by having a constitution where a metal plate is stuck to a single crystal plate which is formed by making a single crystal plate made of a Pb(Zn_{1/3}Nb_{2/3}) O₃-PbTiO₃ solid solution single crystal (PZNT) or a Pb(Mg_{1/3}Nb_{2/3}) O₃-PbTiO₃ (PMNT) solid solution single crystal according to claim 1. Note that the above described PZNT or PMNT according to the present invention includes the piezoelectric single crystal material as described in the above described patent document 1.

In the above described piezoelectric device, the single crystal plate brought into a mono-domain is formed into a single crystal plate in which piezoelectric characteristic values immediately after polarization is kept as they are, and no secular deterioration occurs. Further, according to the present invention, there is provided a piezoelectric device which is a piezoelectric unimorph and has a bending-vibration-mode electromechanical coupling factor k_{b} not smaller than 50%. Further, according to the present invention, there is provided a piezoelectric device which is a piezoelectric bimorph and has a bending-vibration-mode electromechanical coupling factor k_{b} not smaller than 60%. Here, the above described "piezoelectric characteristic value" is the bending-vibration-mode electromechanical coupling factor k_{b} in a device such as the piezoelectric unimorph or bimorph. However, in a device utilizing the lateral vibration mode, the piezoelectric characteristic value is generally defined as "an electromechanical coupling factor k of the device vibration".

Further, in the piezoelectric device according to the present invention, six faces of the mono-domain single crystal plate are preferably used as the face for preventing the movement of the domain wall. Further, it is possible to effectively prevent the secular deterioration of the piezoelectric characteristic by using the metal plate stuck to the single crystal plate and the adhesion layer therebetween as the member for preventing the movement of the domain wall.

The piezoelectric device according to the present invention is constituted as described above, and hence, has a significantly large lateral-effect piezoelectric characteristic as compared with the conventional piezoelectric device, that is, has a giant-lateral-effect piezoelectric characteristic, which results in excellent effects that the bending-vibration-mode electromechanical coupling factor k_{b} can be made large, and that no secular deterioration occurs in such piezoelectric characteristic. Here, "no secular deterioration" means that variation of the piezoelectric characteristic value, for example, after 10000 hours is within ± 2.5% (5% in total) of the original value (immediately after polarization). Further, since the piezoelectric device according to the present invention has the excellent piezoelectric characteristics, it can be utilized in the industrial fields of various piezoelectric sensors and actuators for precision machine instruments and components, electric machines including a relay, a positioner, a motor and the like, acoustic devices including a pickup, a loudspeaker and the like, communication and information input/output media, various measurement devices, or medical appliances and instruments/auxiliary tools, and the like.

### Brief Description of the Drawings

Fig. 1 is a perspective view of a piezoelectric device according to an embodiment.
Fig. 2 is a perspective view of a piezoelectric device according to an embodiment.
Fig. 3 is a perspective view of a single crystal plate used for the embodiments.
Fig. 4 is a graph showing frequency characteristics of a single crystal plate used for the embodiment.
Fig. 5 is a graph showing frequency characteristics of a ceramic of a comparison example.
Fig. 6 is a graph showing frequency characteristics of the piezoelectric device according to the embodiment.
Fig. 7 is a graph showing frequency characteristics of the piezoelectric device of the comparison example.
Fig. 8 is a graph showing frequency characteristics of the piezoelectric device according to the embodiment.
Fig. 9 is a graph showing frequency characteristics of the piezoelectric device of the comparison example.
Fig. 10 is a graph showing the secular change of characteristics of bimorph.

### Best Mode for Carrying Out the Invention

In the following, embodiments according to the present invention are described with reference to the accompanying drawings.

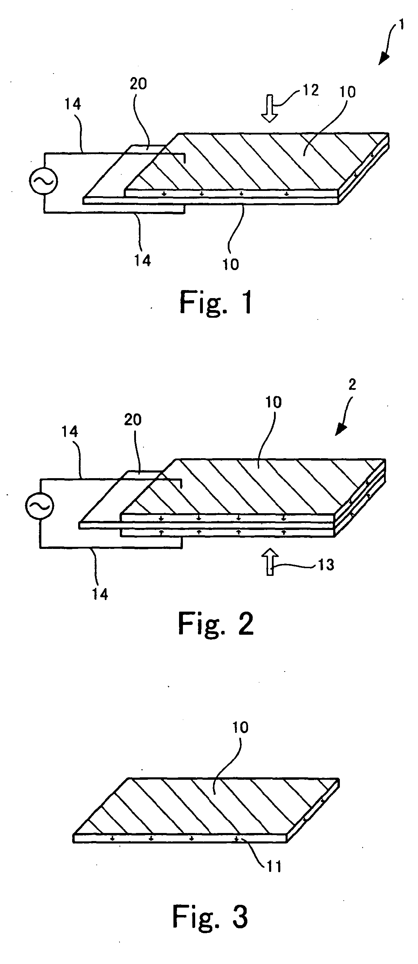

Fig. 3 is a perspective view showing a piezoelectric single crystal 10 which constitutes a piezoelectric device of an embodiment according to the present invention. The piezoelectric single crystal 10 is a plate-like piezoelectric body polarized 11 in its thickness direction by domain control, and is a mono-domain single crystal plate having a lateral-vibration-mode electromechanical coupling factor k₃₁ not smaller than 70 %, and having a piezoelectric distortion constant -d₃₁ not smaller than 1200 pC/N, (that is, having a giant-lateral-effect piezoelectric characteristic). Such giant-lateral-effect piezoelectric characteristic is obtained only in the (100) crystal face at a polarization temperature not higher than 80°C at which PZNT is in the form of rhombohedral, by applying a polarization field sufficient to obtain a mono-domain structure. Note that at room temperature, no secular change in the dielectric characteristic and in the piezoelectric characteristic after saturation polarization occur in the (100) face and the (111) face.

Fig. 1 is a perspective view showing a piezoelectric unimorph 1 according to the present embodiment, and Fig. 2 is a perspective view showing a piezoelectric bimorph 2 according to the present embodiment. The typical piezoelectric devices 1, 2 according to the present invention, utilizing the lateral-effect piezoelectric characteristic, includes the piezoelectric unimorph 1 which is formed, as shown by the arrow 12 in Fig. 1, by sticking a plate-like piezoelectric body (piezoelectric single crystal) 10 polarized in its thickness direction as shown in Fig. 3, to a metal plate (shim plate) 20 having a shape substantially the same as that of the piezoelectric body with an adhesive in a state of aligning the polarization direction, and the piezoelectric bimorph 2 which is formed, as shown by the arrow 13 in Fig. 2, by further sticking a piezoelectric body (piezoelectric single crystal) 10 to the piezoelectric unimorph 1 on the side opposite to the piezoelectric body 10 in Fig. 1, in a state of aligning the polarization direction.

Combinations of the polarization directions 12, 13 of the two piezoelectric bodies 10 are referred to as a series type and a parallel type, respectively. Here, the polarization direction of piezoelectric bodies 10, 10 of the piezoelectric device 2 shown in Fig. 2 is the series type. The upper and lower electrode surfaces of the piezoelectric body 10 are sandwiched by a measurement tool 14 to make it possible to measure the dielectric characteristic and the piezoelectric characteristic of the unimorph or the bimorph.

The piezoelectric devices 1, 2 according to the present invention can be fabricated in a manner as described below.

First, a plate-like Pb[(Zn_{1/3}Nb_{2/3}) _{0.91}Ti_{0.09}] O₃ (PZNT91/09) single crystal 10 having, for example, 13mmlength × 4.0 mmwidth × 0.36 mm thickness, is brought into a mono-domain by controlling the polarization field. Next, the frequency characteristic of element impedance is measured to confirm the values of the giant-lateral-effect piezoelectric characteristic (k₃₁ not smaller than 70%, -d₃₁ not smaller than 1200 pC/N).

As the metal plate (shim plate) 20 shown in Fig. 1 and Fig. 2, for example, there are used two kinds of metal plates, one of which is made of 42 nickel alloy and has a shape with 15 mm length × 4.0 mm width × 0.10 mm thickness, and the other of which is made of phosphor bronze and has a shape with 15 mm length × 4.0 mm width × 0.20 mm thickness.

As for the adhesive, for example, in the case of the PZNT91/09 piezoelectric single crystal, there are used two types of adhesives of a single-liquid type and a two-liquid type, which have an adhesion solidification temperature not higher than 80°C, to study the adhesion state and the workability during adhesion, and the like. The two-liquid type adhesive consists of a main agent and a solidifying agent. By measuring the dielectric loss and the relative dielectric constant εr of the piezoelectric unimorph or the piezoelectric bimorph, (where εr is the abbreviation for relative dielectric constant and is defined as εr = ε₃₃^{T}/ε₀, and ε₀ is the dielectric constant of vacuum), the adhesiveness of the adhesive, such as the uniformity of adhesion and the thickness of adhesion layer, and the effects of the adhesive itself on the dielectric characteristics are clarified. As a prototype of the piezoelectric bimorph, a series type of the piezoelectric bimorph is fabricated.

For comparison, a piezoelectric unimorph and a piezoelectric bimorph, which are made of a PZT-based piezoelectric ceramic (k₃₁ = 37% / d₃₁ = -330 pC/N) and have a shape that is the same as that of the prototype and a large lateral-vibration-mode piezoelectric characteristic, are also fabricated.

Next, the vibration characteristic of the piezoelectric device is evaluated.

First, the vibration characteristic including the bending vibration mode of the piezoelectric unimorph or the piezoelectric bimorph is analyzed by measuring the frequency characteristic of their impedance. The bending-vibration-mode electromechanical coupling factor k_{b} is calculated. On the basis of the calculated result, whether the giant-lateral-effect of the piezoelectric single crystal is effectively utilized in the piezoelectric device or not is evaluated in comparison with the piezoelectric device using the piezoelectric ceramic. The evaluation results are shown in Table 1. Note that each numerical value in Table 1 is calculated in the following manner.

The values of K₃₁, d₃₃ and k_{b} for piezoelectric single crystal elements after polarization processing and for devises using the piezoelectric single crystal elements, are calculated on the basis of the impedance curve and the phase for the modes of k₃₁ and k_{b}, which are obtained by using the impedance gain phase analyzer (HP 4194A made by H.P. Co., Ltd.), by means of the known formula (see the standards of the Electronic Materials Manufacturers Association of Japan: EMAS-6008, 6100). The relative dielectric constant εr for the piezoelectric single crystal elements after polarization processing is calculated by the electrostatic capacitance (capacitance) obtained by using the impedance analyzer (YHP4192A: LF IMPEDANCE ANALYZER made by Y.H.P. Co., Ltd) and the shape of the elements. The piezoelectric distortion constant (d₃₃) is directly measured by using the d₃₃ meter made in China (PIEZO d₃₃ METER Model ZJ-30 made by INSTITUTE of ACOUSTiCS ACADEMIA SINICA).

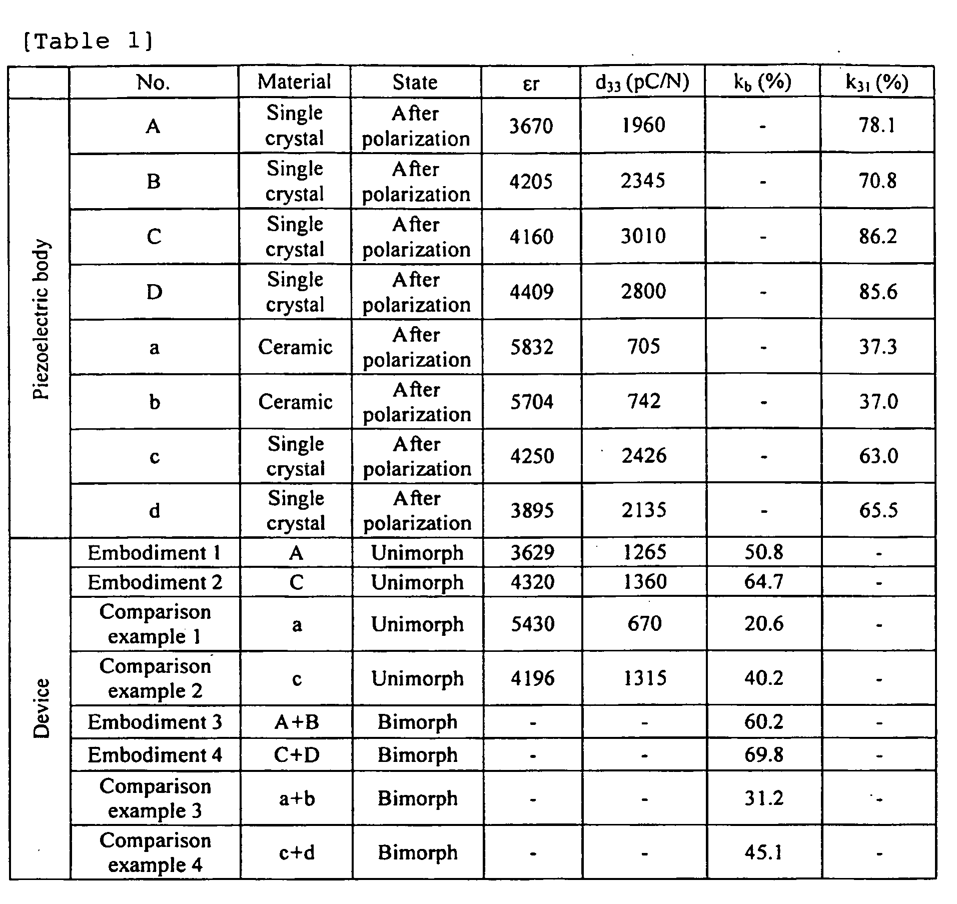

Piezoelectric bodies A, B, C, D shown in Table 1 are piezoelectric single crystals used for the piezoelectric devices according to the present invention, piezoelectric bodies a, b shown in Table 1 are piezoelectric ceramics used for the piezoelectric devices as the comparison example, and piezoelectric bodies c, d shown in Table 1 are piezoelectric single crystals which are not provided with a giant-lateral-effect piezoelectric characteristic. Each of these piezoelectric bodies has a rectangular plate shape having 13 mm length × 4 mm width × 0. 36 thickness. In addition, the metal plate (shim plate) is a 42 nickel-alloy plate.

The piezoelectric bodies A, B, C and D are mono-domain piezoelectric single crystals subjected to the processing for providing the giant-lateral-effect piezoelectric characteristic. That is, each of the piezoelectric bodies A, B, C and D is a single crystal which has a lateral-vibration-mode electromechanical coupling factor k₃₁ not smaller than 70%, and a piezoelectric distortion constant -d₃₁ not smaller than 1200 pC/N. The piezoelectric bodies a and b are the piezoelectric ceramics used as the comparison example. The piezoelectric bodies c and d are single crystals made of PZNT91/09, but are piezoelectric single crystals which are not provided with the giant-lateral-effect piezoelectric characteristic, and which are used for the piezoelectric device as the comparison example. Note that εr in Table 1 represents the dielectric constant.

The embodiment 1 in the table 1 is a piezoelectric unimorph using the above described piezoelectric body A, and the embodiment 2 is a piezoelectric unimorph using the above described piezoelectric body C. The bending-vibration electromechanical coupling factors k_{b} of the embodiments 1 and 2 are 50.8% and 64.7%, respectively.

On the other hand, the comparison example 1 is a piezoelectric unimorph using the piezoelectric body a made of the above described piezoelectric ceramic, and the comparison example 2 is a piezoelectric unimorph using the above described piezoelectric body c made of the piezoelectric single crystal. The bending-vibration-mode electromechanical coupling coefficients k_{b} of the comparison examples 1 and 2 are very small values of 20.6% and 40.2%, respectively.

The embodiment 3 is a series type piezoelectric bimorph using (the piezoelectric body A + the piezoelectric body B) as described above, and the embodiment 4 is a series type piezoelectric bimorph using (the piezoelectric body C + the piezoelectric body D). The bending-vibration electromechanical coupling factors k_{b} of the embodiments 3 and 4 are 60.2% and 69.8%, respectively. The comparison example 3 is a series type piezoelectric bimorph using (the piezoelectric body a + the piezoelectric body b) which are made of the piezoelectric ceramic, and the comparison example 4 is a series type piezoelectric bimorph using (the single crystal c + the single crystal d) as described above. The bending-vibration electromechanical coupling factors k_{b} of the comparison examples 3 and 4 are 31.2% and 45.1%, respectively, and hence, the electromechanical coupling factor k_{b} not smaller than 60% as in the present invention cannot be achieved by the comparison examples 3 and 4.

Next, the vibration characteristics of the piezoelectric unimorph and the piezoelectric bimorph are evaluated.

First, the piezoelectric body used as a base material is explained.

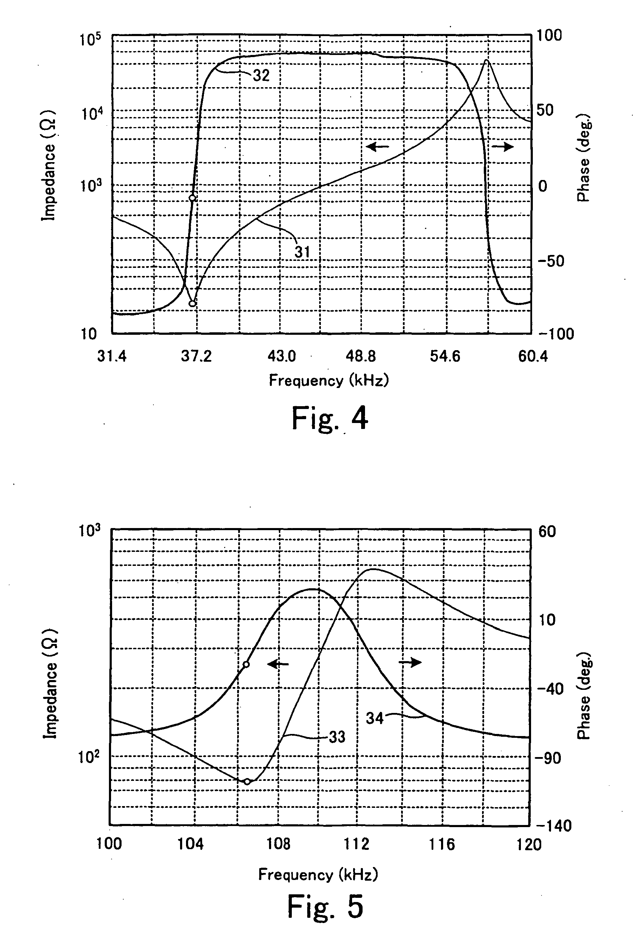

Fig. 4 shows frequency characteristics of element impedance of the PZNT91/09 single crystal itself, in the mode of the lateral-vibration-mode electromechanical coupling factor k₃₁. The curve 31 is an impedance curve, and the curve 32 is a phase curve. The single crystal shown in Fig. 4 has an electromechanical coupling coefficient k₃₁ of 85.6 to 86.2%. Fig. 5 shows frequency characteristics of element impedance of the PZT ceramic itself, corresponding to Fig. 4. The curve 33 is an impedance curve, and the curve 34 is a phase curve. In the PZT ceramic shown in Fig. 5, the lateral-vibration-mode electromechanical coupling factor k₃₁ is 37.0 to 37.3%

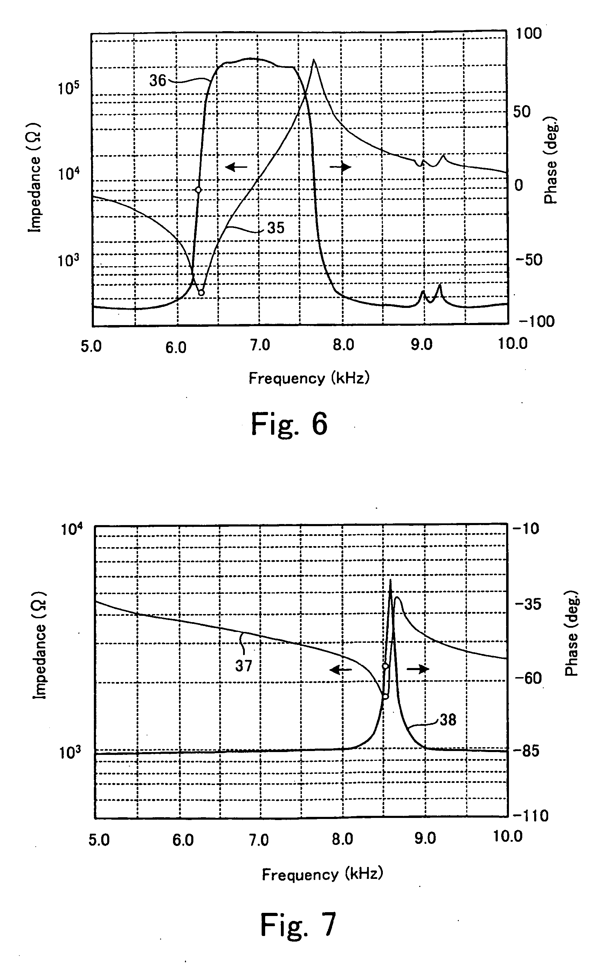

Fig. 6 shows frequency characteristics of element impedance of the piezoelectric unimorph according to the embodiment using the PZNT91/09 single crystal, in the mode of the bending-vibration electromechanical coupling factor k_{b}. The curve 35 is an impedance curve and the curve 36 is a phase curve. The bending-vibration electromechanical coupling factor k_{b} in Fig. 6 is 64.7%. Fig. 7 shows frequency characteristics of impedance of the piezoelectric unimorph of the comparison example using the PZT ceramic corresponding to Fig. 6. The curve 37 is an impedance curve, and the curve 38 is a phase curve. The bending-vibration electromechanical coupling factor k_{b} of the piezoelectric unimorph using the PZT ceramic shown in Fig. 7 is 20.6%.

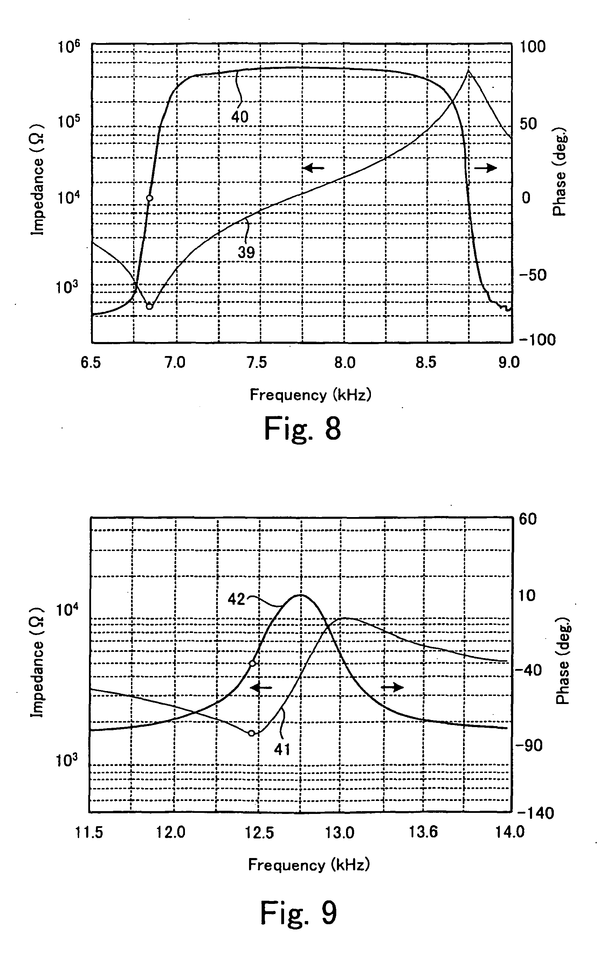

Fig. 8 shows frequency characteristics of element impedance of the piezoelectric bimorph using the PZNT91/09 single crystal, in the mode of the bending-vibration electromechanical coupling factor k_{b}. The curve 39 is an impedance curve, and the curve 40 is a phase curve. The bending-vibration electromechanical coupling factor k_{b} of the piezoelectric bimorph using the PZNT91/09 shown in Fig. 8 is 69.8%. Fig. 9 shows frequency characteristics of impedance of the piezoelectric bimorph of the comparison example using the PZT ceramic corresponding to Fig. 8. The curve 41 is an impedance curve, and the curve 42 is a phase curve. The bending-vibration electromechanical coupling factor k_{b} of the piezoelectric bimorph of the comparison example using the PZT ceramic shown in Fig. 9 is 31.2%.

As is apparent from the foregoing, the piezoelectric unimorph or the piezoelectric bimorph according to the present invention, using the piezoelectric single crystal made of PZNT91/09 or PMNT, has the lateral-vibration-mode electromechanical coupling factor k₃₁ not smaller than 70% and the piezoelectric distortion constant -d₃₁ not smaller than 1200 pC/N, that is, has the giant-lateral-effect piezoelectric characteristic, and hence, is extremely excellent in the lateral vibration characteristic as compared with the conventional ones. Further, it is also apparent that the piezoelectric device according to the present invention has a peak-to-bottom ratio in the impedance curve (non-resonant resistance/resonant resistance) which is larger by three digits than that of the piezoelectric device using the PZT ceramic, and hence, exhibits an excellent piezoelectric characteristic.

Next, evaluation results of the secular characteristic of the piezoelectric device according to the present invention are explained.

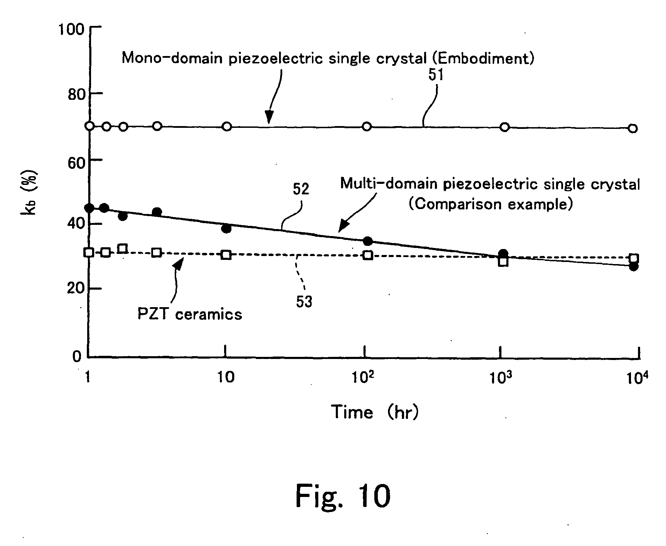

First, variation of the bending-vibration-mode electromechanical coupling factor k_{b} with the lapse of time under room temperature is clarified. Fig. 10 is a graph showing the variation of the bending-vibration-mode electromechanical coupling factor, in which the horizontal axis indicates the time (hr) (represented by a logarithmic scale), and the vertical axis indicates the value of bending-vibration electromechanical coupling factor k_{b}, and showing the situation where values of the factor change with the lapse of time. The curve 51 is a secular change curve of the piezoelectric bimorph of the above described embodiment 4 using the mono-domain piezoelectric single crystal (PZNT91/09). This piezoelectric single crystal plate, which has 13 mm length × 4 mm width × 0.36 mm thickness, and which is brought into a mono-domain to obtain a giant-lateral-effect piezoelectric characteristic, is made of PZNT91/09 having k₃₁ not smaller than 70%, k₃₃ of 95% and d₃₃ not smaller than 2500 pC/N. In the piezoelectric bimorph, which is brought into the mono-domain in its single crystal plate surface (having 13 mm length × 4 mm width), the original value of 70% of the bending-vibration electromechanical coupling factor k_{b} is kept without any deterioration after passage of about one year. Note that a phosphor bronze plate is used as the shim material at this time.

On the other hand, the curve 52 is a secular change curve of the piezoelectric bimorph using the piezoelectric single crystal of the comparison example which is brought into a multi-domain in its single crystal plate surface (having 13 mm length × 4 mm width). This multi-domain piezoelectric single crystal is made of PZNT91/09 having k₃₁ of 66%, k₃₃ of 92%, and d₃₃ of 2426 pC/N. The original value 45% of the bending-vibration electromechanical coupling factor k_{b} is deteriorated with the lapse of time, to be lowered by up to 29% to become approximately 2/3 of the original value after one year.

The curve 53 represents a secular change of the bending-vibration electromechanical coupling factor k_{b} of the piezoelectric bimorph of the comparison example using the PZT ceramic. The value of the bending-vibration electromechanical coupling factor k_{b} is as low as 32% from the beginning, and is almost unchanged after one year. In the PZT ceramic which has a crystal grain diameter of 2 to 5 µm, the movement of the domain wall after polarization is pinned by the crystal grain boundary, so that the domain structure is almost fixed to have a value immediately after polarization. Therefore, the PZT ceramic hardly exhibits any change with the lapse of time.

In the secular change curve 52 of the piezoelectric bimorph using the above described multi-domain piezoelectric single crystal, the original value of the bending-vibration electromechanical coupling factor k_{b} is 45%, but the value deteriorates with the lapse of time to become the same as that in the secular change curve 53 of the piezoelectric bimorph using the PZT ceramic after one year. This is because the multi-domain piezoelectric single crystal, in which the domain wall is easily moved, is thereby changed to a more stable multi-domain piezoelectric single crystal with the lapse of time.

Next, the effect of adhesion and the like on a single crystal ferroelectric domain is evaluated and clarified by directly observing the single crystal ferroelectric domain. That is, the behavior of the domain is studied by directly observing the domain using a transmission type polarization stereoscopic microscope, as a result of which a condition for stably realizing a mono-domain is found. The evaluation result of the effect of adhesion and the like on the single crystal ferroelectric domain is explained as follows.

In the mono-domain PZNT single crystal having a giant k₃₁, after it is stuck to a metal plate (shimplate), its unimorph and bimorph characteristics may be changed due to (i) the effect of the stress generated between the single crystal and the metal plate, that is, in the contact interface between the single crystal and the shim plate, on the mono-domain, (ii) the effect of the stress generated due to the difference in thermal expansion coefficient between the single crystal and the shim plate on the mono-domain, and the like. In the conventional PZT ceramic, the effect of the stress given to the domain orientation from the outside is retained within crystal grains having the size of 2 to 5 µm. On the other hand, in the single crystal, there is no crystal grain boundary, and hence, the movement (change) of the domain wall cannot be pinned (prevented) so that the effect of the stress from the outside is exerted on the entire single crystal plate. In this case, it is expected that the characteristic of the piezoelectric device be significantly changed.

Therefore, the selection of the adhesive material and the examination of the adhesion method, which have no effect on the mono-domain, are of particular importance. The optimum conditions relating such as to the surface roughness of the single crystal and the shim plate need to be found from a viewpoint whether or not the stress is generated in the contact interface between the single crystal and the shim plate.

Further, the effect of the adhesive material and the adhesion method on the reliability of the dielectric and piezoelectric characteristics changing with the lapse of time, is examined from a viewpoint of practical application of the piezoelectric device. In the following, the adhesive having a significant effect on the ferroelectric domain is explained.

A Pb[(Zn_{1/3}Nb_{2/3}) _{0.955}Ti_{0.045}] O₃ (PZNT95.5/4.5) single crystal plate (with 13 mm length × 4 mmwidth × 0. 36 mm thickness) subjected to polarization processing in its thickness direction, and a slide glass plate (with 0.10 mm thickness) having the same shape as that of the above described shim material, are stuck to each other by two kinds of adhesives of a normal temperature solidifying two-liquid type epoxy resin and a normal temperature solidifying single-liquid type cyanoacrylate material, so as to be formed into a piezoelectric unimorph. The surface of the obtained unimorph plate (with 13 mm length x 4 mm width) is observed by the transmission type polarization stereoscopic microscope under crossed Nicols (orthogonal polarization), to investigate how the number of ferroelectric domains is changed by the adhesion.

Table 2 shows the number of domains (number) in the single crystal plate (with 13 mm length × 4 mm width) before and after the adhesion, in the cases of the mono-domain PZNT95.5/4.5 single crystal plate (embodiment 5) which has a giant piezoelectric performance (k₃₁=86.0%), and of the multi-domain PZNT95.5/4.5 single crystal plate (comparison example 5) which is a prior art form with k₃₁=64.0%.

It can be seen from Table 2 that in the single crystal plate of the embodiment 5 which has the giant piezoelectric performance, the number of domains before and after the adhesion is not changed regardless of the adhesives, and that the mono-domain is kept. On the other hand, it can be seen from Table 2 that in the multi-domain single crystal plate of the comparison example 5, the number of domains after the adhesion is increased by 1.5 to 2 times the number of domains before the adhesion, and that the change in the number of domains is also changed depending upon the adhesive materials. It is considered that the change in the number of ferroelectric domains directly influences the value of the lateral-vibration-mode electromechanical coupling coefficient k₃₁, and that the increase in the domain number corresponds to the decrease of polarization relating to the lateral vibration mode.

Further as a result of observing in detail the mono-domain single crystal plate by transmitted polarized light, the state where the stress is concentrated near six faces of the single crystal plate, near the shim material and the adhesive layer, is observed. That is, it is considered that this stress concentration is the motive force by which the mono-domain quality is kept, and that the six faces of the single crystal plate, the shim material and the adhesive layer have an effect of pinning (preventing) the generation of the domain wall (boundary between domains) (multi-domain formation).

On the other hand, it is considered that in the multi-domain single crystal plate, the domain walls already existing in the single crystal plate are moved to relax the stress generated by adhesion with the shim material, and changed to a more stable domain state. Further, it is also possible to explain the secular deterioration of the piezoelectric performance of the piezoelectric device using the multi-domain single crystal plate through the phenomena relating to the stress caused by forming the device and the movement of the domain wall.

**[Table 2]**

| | Number of ferroelectric domains (13 mm length x 4 mm width) | | | |
|---|---|---|---|---|
| | Epoxy resin (two-liquid type) | | Cyanoacrylate material (single-liquid type) | |
| | Before adhesion | After adhesion | Before adhesion | After adhesion |
| Embodiment 5 (k₃₁=_{86.0%}) | One (mono-domain) | One (mono-domain) | One (mono-domain) | One (mono-domain) |
| Comparison example 5 (k₃₁=64.0%) | Eight (multi-domain) | Thirteen (multi-domain) | Eleven (multi-domain) | Twenty (multi-domain) |

## Claims

1. A piezoelectric device formed by sticking to a metal plate a single crystal plate which is made of a Pb (Zn_{1/3}Nb_{2/3}) O₃-PbTiO₃ solid solution single crystal or a Pb (Mg_{1/3}Nb_{2/3}) O₃-PbTiO₃ solid solution single crystal, and which is brought into a mono-domain in the thickness direction and in the plate surface to impart a giant-lateral-effect piezoelectric characteristic thereto, while the mono-domain is kept as it is
**characterized in that**
the single crystal plate is stuck to the metal plate by use of an adhesive between the single crystal plate and the metal plate, the adhesive comprising two type of adhesives of a single-liquid type and two-liquid type which have an adhesion solidification temperature of 80°C or less,
the single crystal plate is a single crystal plate whose piezoelectric characteristic is not deteriorated from a value immediately after polarization with the lapse of time.

2. The piezoelectric device according to claim 1, formed by making the single crystal plate and the metal plate repeatedly laminated with each other.

3. The piezoelectric device according to claim 1 or 2, formed as a piezoelectric unimorph and having a bending-vibration-mode electromechanical coupling coefficient k_{b} not smaller than 50%.

4. The piezoelectric device according to claim 1 or 2, formed as a piezoelectric bimorph and having a bending-vibration-mode electromechanical coupling coefficient k_{b} not smaller than 60%.

5. The piezoelectric device according to any one of claims 1 to 4, wherein six faces of the mono-domain single crystal plate are used as a face which prevents domain wall movement.

6. The piezoelectric device according to any one of claims 1 to 4, wherein the metal plate and adhesive layer that sticks the single crystal plate are used as a member which prevents domain wall movement.

## Patentansprüche

1. Piezoelektrische Vorrichtung, die durch Ankleben einer Einkristallscheibe, die aus einem Pb (Zn_{1/3}Nb_{2/3}) O₃-PbTiO₃-Mischkristall-Einkristall oder einem Pb (Mg_{1/3}Nb_{2/3}) O₃-PbTiO₃-Mischkristall-Einkristall hergestellt ist und in Richtung der Dicke und in der Scheibenoberfläche in eine Monodomäne überführt ist, um dieser eine piezoelektrische Eigenschaft mit grossem lateralen Effekt zu verleihen, während die Monodomäne so beibehalten wird wie sie ist, auf eine Metallscheibe gebildet ist,
**dadurch gekennzeichnet, dass**
die Einkristallscheibe unter Verwendung eines Klebstoffs zwischen der Einkristallscheibe und der Metallscheibe an die Metallscheibe angeklebt wird, wobei der Klebstoff zwei Typen von Klebstoffen eines Einzelflüssigkeitstyps und eines Doppelflüssigkeitstyps umfasst, die eine Klebeverfestigungstemperatur von 80°C oder weniger aufweisen, wobei die Einkristallscheibe eine Einkristallscheibe ist, deren piezoelektrische Eigenschaft, ausgehend von einem Wert unverzüglich nach Polarisation, mit Ablauf der Zeit nicht verschlechtert wird.

2. Piezoelektrische Vorrichtung gemäss Anspruch 1, die gebildet wird, indem die Einkristallscheibe und die Metallscheibe mehrfach miteinander laminiert werden.

3. Piezoelektrische Vorrichtung gemäss Anspruch 1 oder 2, die als piezoelektrischer Unimorph gebildet ist und einen elektromechanischen Kopplungsfaktor im Biegeschwingungsmodus k_{b} von nicht kleiner als 50 % aufweist.

4. Piezoelektrische Vorrichtung gemäss Anspruch 1 oder 2, die als piezoelektrischer Bimorph gebildet ist und einen elektromechanischen Kopplungsfaktor im Biegeschwingungsmodus k_{b} von nicht kleiner als 60 % aufweist.

5. Piezoelektrische Vorrichtung gemäss mindestens einem der Ansprüche 1 bis 4, wobei sechs Ebenen der Monodomänen-Einkristallscheibe als Ebenen verwendet werden, die die Domänenwandbewegung verhindern.

6. Piezoelektrische Vorrichtung gemäss mindestens einem der Anspräche 1 bis 4, wobei die Metallscheibe und die Klebeschicht, die die Einkristallscheibe anklebt, als Element verwendet werden, das die Domänenwandbewegung verhindert.

## Revendications

1. Dispositif piézoélectrique formé en collant à une plaque métallique une plaque monocristalline qui est faite d'une solution monocristalline solide de Pb(Zn_{1/3}Nb_{2/3})O₃-PbTiO₃ ou d'une solution monocristalline solide de Pb(Mg_{1/3}Nb_{2/3})O₃-PbTiO₃, et qui est mise dans un monodomaine dans la direction d'épaisseur et dans la surface de plaque pour conférer à celle-ci une caractéristique d'effet piézoélectrique latéral géant, alors que le monodomaine est maintenu tel qu'il est,
**caractérisé en ce que**
la plaque monocristalline est collée à la plaque métallique par utilisation d'un adhésif entre la plaque monocristalline et la plaque métallique, l'adhésif comprenant deux types d'adhésifs d'un type liquide unique et du type deux liquides qui ont une température de solidification d'adhésion de 80°C ou moins, la plaque monocristalline est une plaque monocristalline dont une caractéristique piézoélectrique n'est pas détériorée à partir d'une valeur immédiatement après polarisation avec l'écoulement du temps.

2. Dispositif piézoélectrique selon la revendication 1, formé en fabriquant la plaque monocristalline et la plaque métallique répétitivement laminée l'une avec l'autre.

3. Dispositif piézoélectrique selon la revendication 1 ou 2, formé comme un unimorphe piézoélectrique et ayant un coefficient de couplage électromécanique en mode vibration-courbure k_{b} non inférieur à 50 %.

4. Dispositif piézoélectrique selon la revendication 1 ou 2, formé comme un bimorphe piézoélectrique et ayant un coefficient de couplage électromécanique en mode vibration-courbure k_{b} non inférieur à 60 %.

5. Dispositif piézoélectrique selon l'une quelconque des revendications 1 à 4, dans lequel six faces de la plaque monocristalline monodomaine sont utilisées comme une face qui empêche le déplacement de paroi de domaine.

6. Dispositif piézoélectrique selon l'une quelconque des revendications 1 à 4, dans lequel la plaque métallique et une couche adhésive qui colle la plaque monocristalline sont utilisées comme un élément qui empêche le déplacement de paroi de domaine.
